# EUROPÄISCHE PATENTSCHRIFT

(11) **EP 2 279 527 B1**
(45) Veröffentlichungstag und Bekanntmachung des Hinweises auf die Patenterteilung: **13.12.2017**
(21) Anmeldenummer: 09753510.8
(22) Anmeldetag: 17.04.2009
(51) Int. Cl.: F21K 9/00, F21V 17/10, H01L 25/075, F21S 8/10, F21V 5/04, F21V 17/06, H01L 33/58

(54) **OPTOELEKTRONISCHE ANORDNUNG**
OPTOELECTRONIC ARRANGEMENT
ENSEMBLE OPTOÉLECTRONIQUE

(30) Priorität: 30.05.2008 DE 102008025921; 21.08.2008 DE 102008039147
(43) Veröffentlichungstag der Anmeldung: 02.02.2011
(73) Patentinhaber: OSRAM Opto Semiconductors GmbH, 93055 Regensburg (DE)
(72) Erfinder: SINGER, Frank, 93128 Regenstauf (DE); GRÖTSCH, Stefan, 93077 Lengfeld - Bad Abbach (DE)
(74) Vertreter: Epping - Hermann - Fischer
(86) Internationale Anmeldenummer: PCT/DE2009/000541
(87) Internationale Veröffentlichungsnummer: WO 2009/143794

(56) Entgegenhaltungen:
- EP-A- 1 788 673
- DE-A1- 10 005 795
- DE-A1- 10 053 569
- DE-A1-102007 017 113
- JP-A- 2000 012 874
- JP-A- 2008 089 879
- US-A- 5 930 276
- US-A1- 2005 024 744
- US-A1- 2005 062 055
- US-A1- 2007 235 743
- US-A1- 2008 272 473

## Beschreibung

Für Projektionsvorrichtungen wie beispielsweise Automobilscheinwerfer wird eine Lichtquelle mit einer hohen Leuchtdichte und einer gut definierten Abstrahlcharakteristik benötigt. Durch den Einsatz eines Verbundes aus Leuchtdioden kann eine hohe Leuchtdichte erzeugt werden. Mittels optischer Elemente kann das Licht gebündelt und in einen gewünschten Raumbereich gelenkt werden. Zur Erzielung der gewünschten Abstrahlcharakteristik ist es erforderlich, die optischen Elemente möglichst exakt bezüglich der Leuchtdioden zu positionieren und zu montieren.

In den Druckschriften DE 102004036157 A1 und DE 102005020908 A1 werden optoelektronische Bauelemente mit optischen Elementen beschrieben.

Aus den Druckschriften DE 100 53 569 A1 und US 2007/0 235 743 A sind Anordnungen mit einem strahlungsemittierenden Element und einem optischen Element bekannt, die mittels Aufsätzen relativ zueinander positioniert sind. Die Druckschrift US 2005/062055 A1 (GALLUP KENDRA [US] ET AL; 24. März 2005) offenbart in Abb. 7 eine LED auf einem Träger, über der ein Montageaufsatz mit einer abgestuften plateauförmigen Hervorhebung angeordnet ist. Die Kopplung an das Endstück einer optischen Faser erfolgt mittels einer zusätzlichen Metallhülse, die die plateauförmige Hervorhebung und das Faserendstück miteinander verbindet.

Die Druckschrift US 2005/024744 A1 (FALICOFF WAQIDI [US] ET AL; 3. Februar 2005) offenbart in Abb. 12 eine zweiteilige Linse über einem LED-Chip, wobei der untere Teil der Linse als Verkapselung an den LED-Chip angeformt ist und eine planare Oberfläche aufweist, die von einem elliptischen Außenbereich abgesetzt ist und über die eine flächige Ankopplung zum zweiten oberen Teil der Linse erfolgt, ohne dass Zwischenräume entstehen.

Eine zu lösende Aufgabe besteht darin, ein optoelektronisches Modul anzugeben, das eine möglichst einfache Positionierung optischer Elemente erlaubt. Die Erfindung ist in Anspruch 1 definiert.

Es wird ein optoelektronisches Modul angegeben, das wenigstens einen Leuchtdiodenchip aufweist, der auf einem Träger angeordnet ist.

In einer bevorzugten Ausführungsform sind mehrere Leuchtdiodenchips auf dem Träger angeordnet. Im Folgenden wird deshalb ein optoelektronisches Modul beschrieben, das mehrere Leuchtdiodenchips aufweist. Dabei soll jedoch auch ein optoelektronisches Modul umfasst sein, das nur einen Leuchtdiodenchip aufweist.

Beispielsweise sind die Leuchtdiodenchips als oberflächenmontierbare Bauteile ausgeführt, die auf einer Leiterplatte angeordnet sind.

Auf dem Träger ist ein Montageaufsatz in einer gewünschten Position relativ zu den Leuchtdiodenchips befestigt. Der Montageaufsatz überdeckt die Leuchtdiodenchips zumindest teilweise.

In einer Ausführungsform ist der Montageaufsatz zumindest in seinem Durchstrahlbereich für elektromagnetische Strahlung aus dem Spektralbereich des sichtbaren Lichtes durchlässig. Dabei wird als Durchstrahlbereich der Bereich des Montageaufsatzes bezeichnet, durch den ein Großteil des in den Leuchtdiodenchips erzeugten Lichtes abgestrahlt wird. Ein Großteil heißt zum Beispiel wenigstens 80 %, bevorzugt wenigstens 90 % des abgestrahlten Lichtes. Beispielsweise enthält der Montageaufsatz ein strahlungsdurchlässiges Material wie Glas, eine strahlungsdurchlässige, insbesondere transparente, Keramik, Aluminiumnitrid oder Aluminiumoxid, oder einen strahlungsdurchlässigen, insbesondere transparenten, Kunststoff. Der Montageaufsatz kann auch aus einem derartigen strahlungsdurchlässigen Material bestehen.

In einem anderen Beispiel weist der Montageaufsatz eine Öffnung zur Ausstrahlung des Lichtes auf, die vorzugsweise im Durchstrahlbereich angeordnet ist. In diesem Fall kann der Montageaufsatz auch aus einem Material bestehen, das strahlungsundurchlässig ist, zum Beispiel einem Metall.

Vorzugsweise enthält der Montageaufsatz ein Material, das eine hohe Wärmeleitfähigkeit aufweist. Dadurch können die Leuchtdiodenchips gut gekühlt werden.

Der Montageaufsatz weist eine Strukturierung seiner Oberseite auf, die die Positionierung eines optischen Elementes in einem Abstrahlbereich der Leuchtdiodenchips ermöglicht.

Dazu weist die Unterseite des optischen Elementes eine Strukturierung auf, die wenigstens abschnittsweise komplementär zur Strukturierung des Montageaufsatzes ausgebildet ist. Das optische Element wird zur Montage so auf den Montageaufsatz aufgesetzt, dass die Strukturierung des optischen Elementes in die komplementäre Strukturierung des Montageaufsatzes eingepasst ist. Dadurch ist das optische Element exakt bezüglich des Montageaufsatzes positioniert. Da der Montageaufsatz wiederum exakt bezüglich der Leuchtdiodenchips positioniert ist, ist damit auch das optische Element exakt bezüglich der Leuchtdiodenchips positioniert.

Mittels des Montageaufsatzes ist somit eine exakte und technisch einfache Positionierung eines optischen Elementes möglich. Insbesondere kann das optoelektronische Modul in einfacher Weise auch nach der Auslieferung an einen Kunden nachträglich mit einem gewünschten optischen Element ausgestattet werden.

In einer Variante ist die Strukturierung so ausgebildet, dass die Position des optischen Elementes bezüglich des Montageaufsatzes bis auf eine Rotation um eine Rotationsachse festgelegt ist. In diesem Fall weist die Strukturierung beispielsweise eine Rotationssymmetrie auf.

In einer weiteren Variante legt die Strukturierung des Montageaufsatzes die Position des optischen Elementes und insbesondere seine Orientierung bezüglich einer Rotationsachse eindeutig fest.

In einer Ausführungsform des optoelektronischen Moduls wird das optische Element am Montageaufsatz befestigt.

Das optische Element kann beispielsweise mittels eines Klebers am Montageaufsatz befestigt werden. Vorzugsweise ist der Kleber transparent und weist einen Brechungsindex auf, der an die Brechungsindizes des optischen Elementes und des Montageaufsatzes angepasst ist. Dies ist insbesondere dann wichtig, wenn der Montageaufsatz im Durchstrahlbereich mit dem optischen Element verbunden wird.

In einer weiteren Ausführungsform wird das optische Element nicht am Montageaufsatz, sondern beispielsweise am Träger befestigt. In diesem Fall kann der Montageaufsatz hinsichtlich seiner Funktion als Positionierhilfe optimal ausgestaltet sein, da er nicht mehr zur Befestigung des optischen Elementes geeignet sein muss.

Die Oberseite des Montageaufsatzes kann auf verschiedene Weise strukturiert sein. An der Oberseite des Montageaufsatzes befindet sich eine Hervorhebung. Ein passendes optisches Element weist dann eine Vertiefung auf, die komplementär zu der Hervorhebung ausgebildet ist. Zur Positionierung des optischen Elementes kann das optische Element in einfacher Weise so auf den Montageaufsatz aufgesteckt werden, dass die Hervorhebung in die Vertiefung eingepasst wird.

Beispielsweise sind die Hervorhebungen des Montageaufsatzes zapfenförmig ausgebildet.

Vorzugsweise befinden sich im optischen Element Schlitze, die komplementär zu den Zapfen des Montageaufsatzes angeordnet und ausgebildet sind. Das optische Element kann so auf den Montageaufsatz aufgesetzt werden, dass sich eine Steckverbindung zwischen den Zapfen und Schlitzen ergibt. Auf diese Weise kann das optische Element exakt lateral bezüglich der Leuchtdiodenchips positioniert werden.

Die Hervorhebungen weisen beispielsweise einen kreisförmigen oder rechteckigen Querschnitt auf. Sie können auch stegförmig ausgeführt sein oder einen kreuzförmigen Querschnitt aufweisen.

In einer weiteren Ausführungsform des Montageaufsatzes sind in der Oberseite des Montageaufsatzes Vertiefungen eingebracht. Beispielsweise sind die Vertiefungen schlitzartig ausgebildet. Ein passendes optisches Element weist zapfenförmige Hervorhebungen auf seiner Unterseite auf. Die Strukturierung des Montageaufsatzes und des optischen Elementes kann auch aus einer Kombination aus Vertiefungen und Hervorhebungen bestehen.

In einer weiteren Ausführungsform führt die Vertiefung durch den Montageaufsatz hindurch und bildet eine Öffnung. Vorzugsweise befindet sich die Öffnung im Durchstrahlbereich des Montageaufsatzes, so dass das in den Leuchtdiodenchips erzeugte Licht durch die Öffnung abgestrahlt werden kann. Gemäß der vorliegenden Erfindung weist die Strukturierung des Montageaufsatzes ein Plateau auf. Mit dem Begriff Plateau ist eine ebene Fläche bezeichnet, die gegenüber ihrer Umgebung hervorgehoben oder zurückgesetzt ist und einen großen Teil der Oberseite des Montageaufsatzes einnimmt. Beispielsweise nimmt das Plateau ein Drittel der Fläche der Oberseite des Montageaufsatzes ein. Das Plateau ist im Durchstrahlbereich des Montageaufsatzes ausgebildet. Das optische Element weist dann ebenfalls ein Plateau auf, das komplementär zum Plateau des Montageaufsatzes ausgebildet ist. Gemäß der vorliegenden Erfindung wird eine optoelektronische Anordnung angegeben, die ein optoelektronisches Modul mit einem Montageaufsatz und ein optisches Element umfasst. Das optische Element ist in die Strukturierungen des Montageaufsatzes eingepasst und somit bezüglich der Leuchtdiodenchips positioniert. Gemäß der vorliegenden Erfindung besteht zwischen dem optischen Element und dem Montageaufsatz ein formschlüssiger Kontakt. Gemäß der vorliegenden Erfindung besteht ein formschlüssiger Kontakt zwischen einem hervorgehobenen Plateau des Montageaufsatzes und einem komplementär dazu ausgebildeten, zurückgesetzten Plateau des optischen Elements. In anderen Beispielen kann ein formschlüssiger Kontakt zwischen dem optischen Element und dem Montageaufsatz außerhalb des Plateaubereichs hergestellt sein. Beispielsweise ist das optische Element dann in dem Bereich außerhalb des Plateaubereichs am Montageaufsatz oder am Träger befestigt. Durch den formschlüssigen Kontakt soll die Reflexion des Lichtes an der Grenzfläche zwischen dem Montageaufsatz und dem optischen Element möglichst gering gehalten werden. In einer Ausführungsform ist der Montageaufsatz in dem Bereich des formschlüssigen Kontaktes auch fest mit dem optischen Element verbunden. Beispielsweise kann dazu ein transparenter Kleber verwendet werden.

In einem anderen Beispiel befindet sich zwischen übereinander angeordneten Bereichen des Montageaufsatzes und des optischen Elementes ein Zwischenraum, beispielsweise ein Luftspalt.

Beispielsweise kann ein derartiger Spalt in einem Durchstrahlbereich des Montageaufsatzes vorgesehen sein. In diesem Fall ist das optische Element vorzugsweise in einem Bereich am Montageaufsatz befestigt, der außerhalb des Durchstrahlbereiches liegt. Dies hat den Vorteil, dass auch ein Material zur Verbindung der Bauelemente verwendet werden kann, das nicht transparent für das abgestrahlte Licht ist. Die Strukturierung des Montageaufsatzes wird beispielsweise durch Ätzen, Sandstrahlen oder Fräsen eingebracht.

In einer bevorzugten Ausführungsform werden die Strukturierungen eingebracht, bevor der Montageaufsatz am Träger befestigt wird. Dies hat den Vorteil, dass die Bearbeitung durchgeführt werden kann, ohne dass die Gefahr einer Beschädigung des optoelektronisches Moduls besteht. Danach wird der Montageaufsatz so am Träger befestigt, dass er in geeigneter Weise bezüglich der Leuchtdiodenchips positioniert ist. Gemäß der vorliegenden Erfindung ist an der Unterseite des Montageaufsatzes eine Ausnehmung ausgebildet, die zur Aufnahme der Leuchtdiodenchips dient.

Diese Ausnehmung kann ebenfalls durch Ätzen, Sandstrahlen, oder Fräsen eingebracht werden.

Diese Ausführungsform hat den Vorteil, dass der Montageaufsatz direkt über die Leuchtdiodenchips montiert werden kann, ohne dass ein weiteres Verbindungselement, zum Beispiel ein Abstandshalter, benötigt wird.

Das beschriebene optoelektronische Modul kann beispielsweise als Lichtquelle in einem Scheinwerfer, beispielsweise einem Kfz-Scheinwerfer, oder in einem Projektions- oder Displaysystem eingesetzt werden.

Im Folgenden werden das optoelektronische Modul und seine vorteilhaften Ausgestaltungen anhand von schematischen und nicht maßstabsgetreuen Figuren erläutert. Es zeigen:
- Figur 1: in schräger Aufsicht einen Montageaufsatz, der auf einen Träger aufgebracht wird,
- Figur 2A: in schematischer Schnittansicht ein optoelektronisches Modul mit Montageaufsatz,
- Figur 2B: in schräger Aufsicht ein optoelektronisches Modul mit Montageaufsatz,
- Figur 3A: in schematischer Schnittansicht ein optoelektronisches Modul mit Montageaufsatz, auf dem ein optisches Element aufgesetzt wird,
- Figur 3B: in schematischer Schnittansicht ein optoelektronisches Modul mit Montageaufsatz und einem aufgesetzten optischen Element,
- Figur 4: in schematischer Schnittansicht ein weiteres Ausführungsbeispiel für ein optoelektronisches Modul mit einem Montageaufsatz und einem aufgesetzten optischen Element,
- Figuren 5A bis 5D: in schematischer Aufsicht Montageaufsätze mit verschiedenen Strukturierungen.

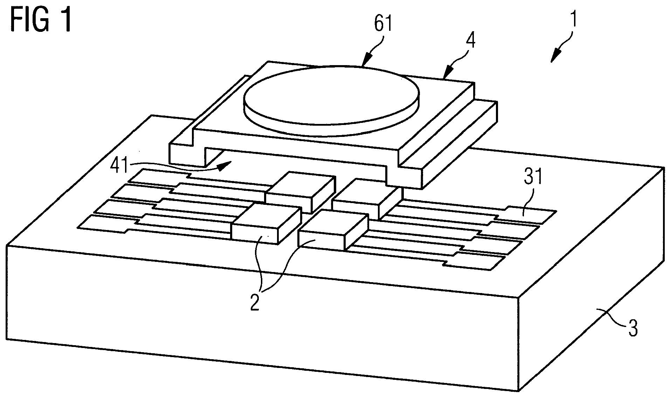

In Figur 1 ist ein Träger 3 zu sehen, auf dem mehrere Leuchtdiodenchips 2 angeordnet sind. Die Leuchtdiodenchips 2 sind mittels Leiterbahnen 31 elektrisch kontaktierbar. Der Träger 3 besteht beispielsweise aus einer Keramik oder aus einem beliebigen anderen geeigneten Material.

Auf den Träger 3 wird ein transparenter Montageaufsatz 4 aufgebracht. An der Unterseite weist er eine Ausnehmung 41 auf, in der die Leuchtdiodenchips 2 aufgenommen werden können. Der Montageaufsatz 4 ist an zwei gegenüberliegenden Seitenflächen nach außen hin geöffnet, so dass ein Luftaustausch mit der Umgebung stattfinden kann. Der Montageaufsatz 4 kann jedoch auch so ausgebildet sein, dass die Leuchtdiodenchips 2 vollständig eingekapselt sind und kein Luftaustausch stattfinden kann. Dies hat den Vorteil, dass die Leuchtdiodenchips 2 besser gegen äußere Einflüsse geschützt sind. Der Montageaufsatz 4 wird beispielsweise auf den Träger 3 aufgeklebt.

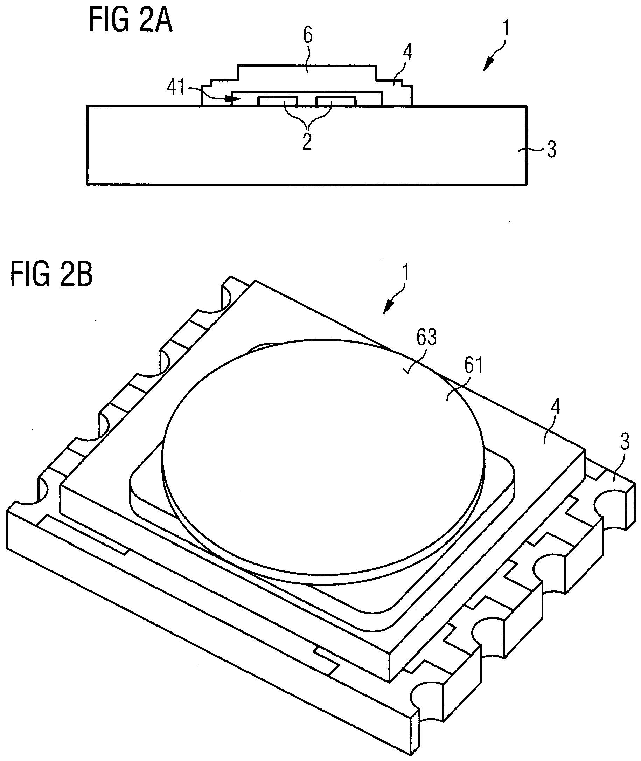

Figur 2A zeigt in schematischer Schnittansicht ein optoelektronisches Modul 1 mit einem aufgesetzten Montageaufsatz 4. In diesem Ausführungsbeispiel überdeckt der Montageaufsatz 4 die Leuchtdiodenchips 2 vollständig. Dadurch sind die Leuchtdiodenchips 2 vor mechanischen Beschädigungen geschützt.

Figur 2B zeigt in schematischer schräger Aufsicht ein optoelektronisches Modul 1 mit einem Montageaufsatz 4, der auf einem Träger 3 befestigt ist. Das optoelektronische Modul 4 weist eine kreisförmige Hervorhebung 61 mit einem Plateau 63 auf, auf die ein optisches Element mit einer entsprechenden Vertiefung aufgesteckt werden kann. In diesem Ausführungsbeispiel sind die Leuchtdiodenchips 2 vollständig vom Montageaufsatz 4 und vom Träger 3 umschlossen und so vor äußeren Einflüssen geschützt.

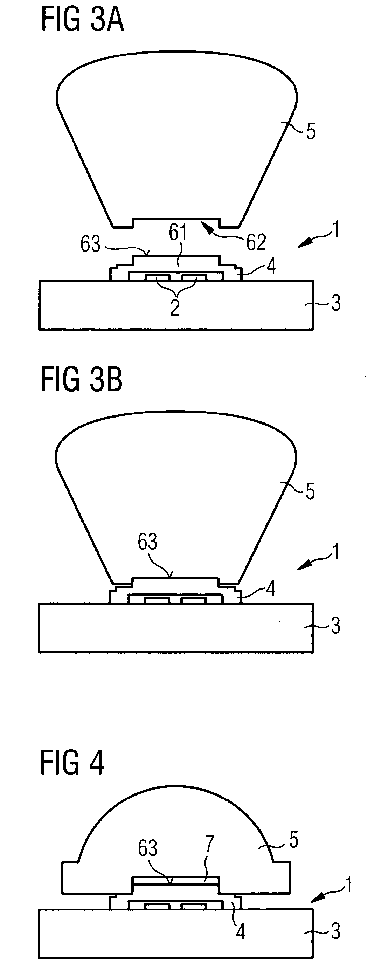

Figur 3A zeigt ein optoelektronisches Modul 1 mit einem Montageaufsatz 4, auf das ein optisches Element 5 aufgebracht wird. Der Montageaufsatz 4 weist eine plateauförmige Hervorhebung 61 auf. Komplementär dazu ist auf der Unterseite des optischen Elements 5 eine entsprechende Vertiefung 62 ausgebildet. Soll das optische Element 5 mit dem Montageaufsatz 4 fest verbunden werden, so wird beispielsweise auf den plateauförmigen Bereichen 62, 63 des optischen Elementes 5 und des Montageaufsatzes 4 ein transparenter Kleber aufgetragen. Da der plateauförmige Bereich 63 im Durchstrahlbereich des Montageaufsatzes angeordnet ist, wird vorzugsweise ein transparenter Kleber verwendet.

Figur 3B zeigt ein optoelektronisches Modul 1, an dem ein optisches Element 5 befestigt ist. Das optische Element 5 ist so auf dem Montageaufsatz 4 aufgesetzt, dass die Hervorhebung 61 in die komplementäre Vertiefung 62 eingepasst ist. Im Bereich des Plateaus 63 besteht ein formschlüssiger Kontakt zwischen dem Montageaufsatz 4 und dem optischen Element 5. In diesem Ausführungsbeispiel ist das optische Element 5 im Plateaubereich 63 fest mit dem Montageaufsatz 4 verbunden, beispielsweise mittels eines transparenten Klebers.

Figur 4 zeigt ein optoelektronisches Modul 1 mit einem Montageaufsatz 4 und einem daran befestigten optischen Element 5. Das optoelektronische Modul 1 ist gemäß dem optoelektronischen Modul 1 in Figur 3B ausgeführt, jedoch mit einem anderen optischen Element 5 ausgestattet. Die Unterseite dieses optischen Elementes 5 ist so strukturiert, dass sich im Bereich des Plateaus 63 ein Zwischenraum 7 zwischen dem optischen Element 5 und dem Montageaufsatz 4 befindet. Hier besteht ein formschlüssiger Kontakt zwischen dem optischen Element 5 und dem Montageaufsatz 4 in einem Bereich des Montageaufsatzes 4, der außerhalb des Plateaus 63 liegt. Beispielsweise ist das optische Element 5 im Bereich des formschlüssigen Kontaktes mittels eines Klebers fest mit dem Montageaufsatz 4 verbunden.

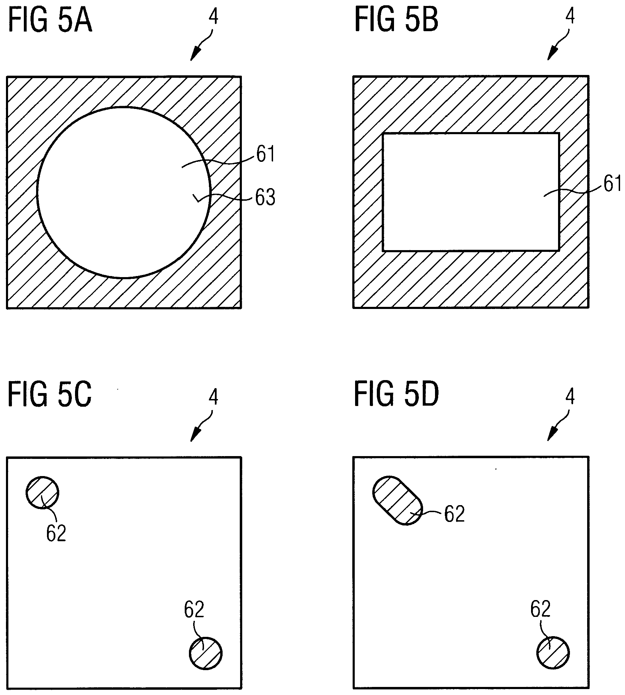

In den Figuren 5A bis 5D sind verschiedene Möglichkeiten für die Strukturierung des Montageaufsatzes 4 dargestellt. Die schraffierten Bereiche sind jeweils gegenüber den nicht schraffierten Bereichen zurückgesetzt.

Der in Figur 5A gezeigte Montageaufsatz 4 weist eine kreisförmige Hervorhebung 61 mit einem Plateau 63 auf. Ein optisches Element weist eine komplementäre Vertiefung auf, und wird, beispielsweise wie in Figur 3B gezeigt, auf den Montageaufsatz 4 aufgesetzt. Die Hervorhebung 61 ist rotationssymmetrisch bezüglich einer Rotationsachse senkrecht zum Plateau 63 ausgebildet. Aufgrund dieser Rotationssymmetrie ist die Positionierung eines optischen Elementes 4 bis auf eine Drehung um diese Rotationssachse festgelegt. Eine rotationssymmetrische Strukturierung ist insbesondere dann sinnvoll, wenn das optische Element 4 ebenfalls rotationssymmetrisch ausgebildet ist. In diesem Fall hat eine Drehung des optischen Elementes 4 um die Rotationssachse keinen Einfluss auf die Ausrichtung des optischen Elementes 4 bezüglich der Leuchtdiodenchips 2. In Figur 5B ist ein Montageaufsatz 4 mit einer Hervorhebung 61 mit einem rechteckigen Querschnitt gezeigt. Ein dazu passendes optisches Element weist eine komplementäre Vertiefung auf. Da die rechteckige Hervorhebung 61 durch eine Drehung um 180° bezüglich einer Rotationssachse senkrecht zum Plateau 63 in sich übergeführt werden kann, ist die Positionierung eines optischen Elementes bis auf eine Drehung um 180° um diese Rotationsachse festgelegt.

Bei dem in Figur 5C gezeigten Montageaufsatz 4 sind Vertiefungen 62 in Form von kreisförmigen Schlitzen ausgebildet. Das optische Element weist vorzugsweise komplementär angeordnete Zapfen auf, die in die Schlitze 62 eingesteckt werden können. Auch hier lässt sich die Strukturierung in Form der zapfenförmigen Vertiefungen 62 durch eine Drehung um 180° bezüglich einer Rotationsachse ineinander überführen. Deshalb kann auch hier ein passendes optisches Element 5 auf zwei verschiedene Arten auf den Montageaufsatz 4 aufgesetzt werden.

Bei dem in Figur 5D dargestellten Montageaufsatz 4 ist ein kreisförmiger und ein länglicher Schlitz 62 ausgebildet. Diese Strukturierung lässt sich nicht durch eine Drehung um einen Winkel größer 0° und kleiner 360° in sich überführen. Deshalb ist hier die Position eines optischen Elementes 5 eindeutig festgelegt.

In anderen Beispielen sind die in den Figuren 5A bis 5D gezeigten schraffierten Bereiche Hervorhebungen und die unschraffierten Bereiche Vertiefungen.

## Patentansprüche

1. Optoelektronische Anordnung mit
- einem optoelektronischen Modul
- mit wenigstens einem Leuchtdiodenchip (2), der auf einem Träger (3) angeordnet ist,
- mit einem Montageaufsatz (4), der am Träger (3) befestigt ist und der den oder die Leuchtdiodenchips (2) zumindest teilweise überdeckt,
- wobei der Montageaufsatz (4) eine ebene vom Träger (3) abgewandte Oberseite und eine Strukturierung (6) an der Oberseite aufweist, die die Positionierung eines optischen Elements (5) ermöglicht,
- einem optischen Element (5), das auf den Montageaufsatz (4) aufgesetzt ist, wobei
- das optische Element (5) eine Strukturierung aufweist, die zumindest abschnittsweise in die Strukturierung (6) des Montageaufsatzes (4) eingepasst ist, wobei
- der Montageaufsatz (4) an einer dem Träger (3) zugewandten Unterseite eine Ausnehmung (41) für den wenigstens einen Leuchtdiodenchip (2) aufweist, deren Abmessungen größer als die des oder der Leuchtdiodenchips (2) sind,
- die Strukturierung (6) des Montageaufsatzes (4) eine von der Oberseite des Montageaufsatzes (4) abgestufte Hervorhebung (61) umfasst,
- die Hervorhebung (61) ein Plateau (63) ist,
- das Plateau (63) in einem Durchstrahlbereich des Montageaufsatzes (4) angeordnet ist, durch den ein Großteil des in dem wenigstens einen Leuchtdiodenchip (2) erzeugten Lichts abgestrahlt wird, und
- die Strukturierung des optischen Elements (5) eine zu dem Plateau (63) komplementäre Vertiefung ist, und zwischen dem Montageaufsatz (4) und dem optischen Element (5) im Durchstrahlbereich des Montageaufsatzes (4) ein flächiger Kontakt besteht.

2. Optoelektronische Anordnung nach Anspruch 1,
bei der der Montageaufsatz (4) die Leuchtdiodenchips (2) vollständig überdeckt.

3. Optoelektronische Anordnung nach einem der vorherigen Ansprüche,
bei der der Montageaufsatz (4) die Leuchtdiodenchips (2) vollständig überdeckt und seitlich vollständig umschließt.

4. Optoelektronische Anordnung nach einem der vorherigen Ansprüche,
bei der an der Oberseite des Montageaufsatzes (4) wenigstens eine zapfenförmige Hervorhebung ausgebildet ist.

5. Optoelektronische Anordnung nach einem der vorherigen Ansprüche,
bei der an der Oberseite des Montageaufsatzes (4) eine Vertiefung (62), insbesondere eine schlitzartige Vertiefung, ausgebildet ist.

6. Optoelektronische Anordnung nach einem der vorherigen Ansprüche,
bei der sich in der Oberseite des Montageaufsatzes (4) eine Öffnung befindet.

7. Optoelektronische Anordnung nach einem der vorherigen Ansprüche,
bei der der Montageaufsatz (4) Glas, eine strahlungsdurchlässige Keramik, Aluminiumnitrid, Aluminiumoxid oder einen strahlungsdurchlässigen Kunststoff enthält.

8. Optoelektronische Anordnung nach einem der vorherigen Ansprüche,
bei der das optische Element (5) am Montageaufsatz (4) befestigt ist.

9. Optoelektronische Anordnung nach einem der vorherigen Ansprüche,
bei der das optische Element (5) am Träger (3) befestigt ist.

## Claims

1. Optoelectronic arrangement with
- an optoelectronic module
- with at least one light-emitting diode chip (2), which is arranged on a carrier (3),
- with a mounting attachment (4), which is attached to the carrier (3) and covers the light-emitting diode chip or chips (2) at least in part,
- wherein the mounting attachment (4) comprises a flat top remote from the carrier (3) and a structuring (6) on the top, which allows the positioning of an optical element (5),
- an optical element (5), which is placed on the mounting attachment (4), wherein
- the optical element (5) comprises structuring, which is fitted at least in places into the structuring (6) of the mounting attachment (4), wherein
- the mounting attachment (4) comprises a recess (41) on an underside facing the carrier (3) for the at least one light-emitting diode chip (2), the dimensions of which recess are greater than those of the light-emitting diode chip or chips (2),
- the structuring (6) of the mounting attachment (4) comprises a raised portion (61) that is graduated from the top of the mounting attachment (4),
- the raised portion (61) is a plateau (63),
- the plateau (63) is arranged in a transmission region of the mounting attachment (4), through which a majority of the light generated in the at least one light-emitting diode chip (2) is radiated, and
- the structuring of the optical element (5) is a recess complementary to the plateau (63), and a two-dimensional contact exists between the mounting attachment (4) and the optical element (5) in the transmission region of the mounting attachment (4).

2. Optoelectronic arrangement according to claim 1, in which the mounting attachment (4) completely covers the light-emitting diode chips (2).

3. Optoelectronic arrangement according to either one of the preceding claims, in which the mounting attachment (4) completely covers the light-emitting diode chips (2) and completely surrounds them laterally.

4. Optoelectronic arrangement according to any one of the preceding claims, in which at least one peg-shaped raised portion is formed on the top of the mounting attachment (4).

5. Optoelectronic arrangement according to any one of the preceding claims, in which a recess (62), in particular a slot-shaped recess, is formed on the top of the mounting attachment (4).

6. Optoelectronic arrangement according to any one of the preceding claims, in which an opening is located in the top of the mounting attachment (4).

7. Optoelectronic arrangement according to any one of the preceding claims, in which the mounting attachment (4) contains glass, a radiation-transmissive ceramic, aluminum nitride, aluminum oxide or a radiation-transmissive plastic.

8. Optoelectronic arrangement according to any one of the preceding claims, in which the optical element (5) is attached to the mounting attachment (4).

9. Optoelectronic arrangement according to any one of the preceding claims, in which the optical element (5) is attached to the carrier (3).

## Revendications

1. Dispositif optoélectronique avec
- un module optoélectronique
- avec au moins une puce à diode électroluminescente (2) disposée sur un support (3),
- avec un support de montage (4) fixé au support (3) et qui couvre au moins partiellement la ou les puce(s) à diode électroluminescente (2),
- dans lequel le support de montage (4) présente une face supérieure plane opposée au support (3) et une structure (6) sur la face supérieure, qui permet le positionnement d'un élément optique (5),
- un élément optique (5) posé sur le support de montage (4), dans lequel
- l'élément optique (5) présente une structure au moins adaptée par sections à la structure (6) du support de montage (4),
dans lequel
- le support de montage (4) présente, sur une face inférieure dirigée vers le support (3), un évidement (41) pour l'au moins une puce à diode électroluminescente (2), dont les dimensions sont supérieures à celles de la ou des puce(s) à diode électroluminescente (2),
- la structure (6) du support de montage (4) présente une mise en relief échelonnée (61) par rapport à la face supérieure du support de montage (4),
- la mise en relief (61) est un plateau (63),
- le plateau (63) est disposé dans une zone de traversée du rayonnement du support de montage (4), à travers laquelle une majeure partie de la lumière générée au sein de l'au moins une puce à diode électroluminescente (2) rayonne,
et
- la structure de l'élément optique (5) est une concavité complémentaire au plateau (63) et un contact à pleine surface existe entre le support de montage (4) et l'élément optique (5) dans la zone de traversée du rayonnement du support de montage (4).

2. Dispositif optoélectronique selon la revendication 1, dans lequel le support de montage (4) recouvre intégralement la puce à diode électroluminescente (2).

3. Dispositif optoélectronique selon l'une des revendications précédentes, dans lequel le support de montage (4) recouvre intégralement la puce à diode électroluminescente (2) et l'entour intégralement latéralement.

4. Dispositif optoélectronique selon l'une des revendications précédentes, dans lequel au moins une mise en relief conoïde est exécutée sur la face supérieure du support de montage (4).

5. Dispositif optoélectronique selon l'une des revendications précédentes, dans lequel une concavité (62), en particulier une concavité en forme de fente, est exécutée sur la face supérieure du support de montage (4).

6. Dispositif optoélectronique selon l'une des revendications précédentes, dans lequel un orifice se situe dans la face supérieure du support de montage (4).

7. Dispositif optoélectronique selon l'une des revendications précédentes, dans lequel le support de montage (4) contient du verre, une céramique perméable au rayonnement, du nitrure d'aluminium, de l'oxyde d'aluminium ou un plastique perméable au rayonnement.

8. Dispositif optoélectronique selon l'une des revendications précédentes, dans lequel l'élément optique (5) est fixé sur le support de montage (4).

9. Dispositif optoélectronique selon l'une des revendications précédentes, dans lequel l'élément optique (5) est fixé sur le support (3).
